**Europäisches Patentamt**

**European Patent Office**

**Office européen des brevets**

(19)

(11) Veröffentlichungsnummer: **0 268 161 B1**

(12) **EUROPÄISCHE PATENTSCHRIFT**

(45) Veröffentlichungstag der Patentschrift:
28.03.90

(51) Int. Cl.⁴: **G01D 5/16**, G01R 17/10

(21) Anmeldenummer: **87116368.9**

(22) Anmeldetag: **06.11.87**

(54) **Einrichtung zur Erfassung und Übertragung einer Messgrösse.**

(30) Priorität: **18.11.86 DE 3639340**

(43) Veröffentlichungstag der Anmeldung:
**25.05.88 Patentblatt 88/21**

(45) Bekanntmachung des Hinweises auf die Patenterteilung:
**28.03.90 Patentblatt 90/13**

(84) Benannte Vertragsstaaten:
**AT CH FR GB IT LI**

(56) Entgegenhaltungen:
**AT-B- 183 570**
**DE-A- 2 814 865**
**DE-A- 3 435 867**

(73) Patentinhaber: **Arnold Müller GmbH & Co. KG,
Klosterstrasse 48, D-7312 Kirchheim/Teck(DE)**

(72) Erfinder: **Schwarz, Bernhard, Dr. Ing., Ehrlichweg 8,
D-7000 Stuttgart 80(DE)**
Erfinder: **Harig, Klaus, Dr. Ing., Rote Steige 5,
D-7400 Tübingen(DE)**

(74) Vertreter: **Kratzsch, Volkhard, Dipl.-Ing.,
Mülbergerstrasse 65, D-7300 Esslingen(DE)**

## Beschreibung

Die Erfindung betrifft eine Einrichtung zur Erfassung und Übertragung einer Meßgröße, insbesondere einer Gleichgröße mit überlagertem Wechselanteil gemäß dem Oberbegriff des Patentanspruchs 1.

Bei der Meßgrößenerfassung und deren Übertragung in der elektrischen Antriebstechnik ist im allgemeinen die interessierende Meßgröße der Winkel oder die Wegstrecke. Die Drehung der Welle einer elektrischen Maschine wird dabei im Regelfall über ein mechanisches Getriebe z.B. mit Hilfe einer Kugelrollspindel in eine Linearbewegung umgesetzt. Der Winkel ist dann über einen Proportionalfaktor in die Wegstreckke umrechenbar, so daß man sich auf die Betrachtung des Winkels als Meßgröße nachfolgend beschränken kann.

Zur Erzeugung eines binären Signals ist es bekannt, dieses entsprechend dem Vorzeichen eines Analogsignals zu bilden. Das Analogsignal wird durch optische Abtastung einer Strichscheibe oder durch magnetische Abtastung eines Zahnrades erzeugt. Dieses Analogsignal ist näherungsweise sinusförmig über dem Winkel und weist ein ganzzahliges Vielfaches der mechanischen Winkelgeschwindigkeit auf. Dieses Analogsignal wird von der Meßwertgeberseite direkt zur Auswerteseite hin übertragen.

Bei der Übertragung eines binären Signals ist eine relativ geringe Störempfindlichkeit vorhanden. Es ist eine hohe Auflösung mittels einer feinen Teilung der Strichscheibe oder des Zahnrads möglich. Es ergeben sich jedoch bei hohen mechanischen Drehzahlen hohe Folgefrequenzen, wodurch die Maximaldrehzahl eines Antriebes begrenzt wird.

Bei der Übertragung eines analogen Meßwertes ist auch bei grober Teilung durch Auswertung des sinusförmigen Signals theoretisch eine beliebig hohe Auflösung möglich. In der Praxis ist jedoch die Realisierung problematisch, weil eine sehr genaue Erfassung des Augenblickswertes des Analogsignals erforderlich ist. Dies ist deswegen besonders schwierig, weil meist recht lange Zuleitungen vorhanden sind und darüberhinaus in elektrischen Antrieben getaktete Stellglieder verwendet werden, in denen sehr hohe Strom- und Spannungsanstiegsgeschwindigkeiten auftreten. Dadurch wird über die Leitungen in das Ergebnis eingestreut. Eine Minderung des sich daraus ergebenden Störpegels mit Hilfe von Filtern ist infolge der im allgemeinen geforderten hohen Bandbreite des Meßsignals nur bedingt möglich.

Bei Erzeugung und Übertragung von analogen Meßsignalen sind grundsätzlich zwei Prinzipien zu unterscheiden, nämlich die Stromübertragung und die Spannungsübertragung.

Die Spannungsübertragung weist eine wesentlich höhere Störanfälligkeit auf, weswegen sie in zunehmendem Maße durch eine Übertragung mit Stromeinprägung ersetzt wird.

Trotzdem gelangt insbesondere in solchen Fällen, in welchen großer Wert auf eine einfache Ausführungsform der sender- bzw. geberseitigen Meßeinheit gelegt wird, die Spannungsübertragung zum Einsatz. Diese Aussage wird auch durch die seitens der Hersteller von Meßwertgebern veröffentlichten Applikationsbeispiele belegt. So enthält das Siemens Datenbuch 1982/83 "Sensoren-Magnetfeldhalbleiter Teil 1", S. 134 – 139 einen Schaltungsvorschlag, in welchem die beiden Innenwiderstände eines Differential-Feldplatten-Gebers in Reihe geschaltet sind und somit einen Spannungsteiler bilden. Die so gewonnene Teilerspannung dient als Meßsignal und muß übertragen werden. Daran ändert auch die Erweiterung dieser Anordnung zu einer Brückenschaltung und anschließender Erfassung der Brückenspannung nichts.

Die Quelle für die Speisung der Übertragungsleitung befindet sich bei bekannten Systemen stets auf der Sender- bzw. Geberseite.

Es ist leicht verständlich, daß die unmittelbare Umwandlung der zu erfassenden Meßgröße in einen Meßstrom bei allen bekannten Meßwertgebern zu nur sehr kleinen Stromamplituden führt. Ein typischer Wert handelsüblicher Geber liegt bei ca. 11 Mikroampere Spitzenstrom, wie beispielsweise aus dem Prospekt "Baureihe ROD 400, Inkrementale Standard-Drehgeber" August 85 der Dr. Johannes Heidenhain GmbH hervorgeht. Um eine störunempfindlichere Übertragung mit größeren Strömen durchführen zu können, ist eine wesentliche Verstärkung dieses Signals auf der Sender- bzw. Geberseite erforderlich. Die hierzu erforderlichen aktiven und passiven Bauelemente begrenzen jedoch oftmals den zulässigen Temperaturbereich solcher Systeme. Zusätzlich ist eine Energieübertragung auf die Sender- bzw. Geberseite notwendig. Es ist bekannt, daß eine gewisse Verminderung der Störempfindlichkeit dadurch erreicht werden kann, daß zusätzlich zum eigentlich übertragenen Signal das hierzu invertierte Signal erzeugt und übertragen wird. Die Auswertung erfolgt dann auf der Empfängerseite als Differenzmessung.

DE-AS 1 298 729 betrifft eine umschaltbare, mit Stromimpulsen gespeiste Brückenschaltung zur aufeinanderfolgenden Abfrage mehrerer Meßstellen mit drei gemeinsamen und mit mehreren, jeweils einer der Meßstellen zugeordneten, als vierter Brückenwiderstand dienender, zuschaltbarer Meßwiderstand, sogenannte "Viertelsbrücke". Bei dieser Anordnung handelt es sich im Kern um eine konventionelle Brückenschaltung. Sie weist keine Trennung in Sende- und Empfangsseite auf, der Meßwiderstand ist nur in einem Brückenzweig vorhanden und es findet keine Spannungseinspeisung am gemeinsamen Verbindungspunkt zweier in verschiedenen Brückenzweigen liegender Meßwiderstände statt.

Meßtechnische Briefe 19 (1983), Heft 3, S. 63 – S. 67, beschreibt in Zusammenhang mit Bild 3 die Einspeisung eines Konstantstroms über Hin- und Rückleitung in einen Dehnungsmeßstreifen. Die Meßsignalabnahme am Widerstand erfolgt über jeweils wiederum zwei separate Leitungen, so daß es sich insgesamt um eine Anordnung in Vierleitertechnik handelt, die mit vorliegender Erfindung nichts zu tun hat. Bild 6 dieses Artikels beschreibt eine Brückenschaltung, bei der jeweils in Serie die Meßwiderstände und die Brückenwiderstände parallel zueinander und parallel an der Speisespannung liegen. Eine Spannungseinspeisung an der Verbindung der Meßwiderstände findet hier nicht statt, und die Signalabnahme ist gänzlich unterschiedlich von der, die der vorliegenden Erfindung zugrundeliegt.

DE-AS 2 233 598 betrifft eine in Differenzdruckmeßumformern verwendete Dehnungsmeßstreifenwiderstandsbrücke, die im wesentlichen aus zwei Dehnungsmeßstreifen besteht, welche in benachbarten Brückenzweigen geschaltet und innerhalb des Druckraums des Differenzdruckmeßumformers auf einer von der Meßkraft beaufschlagten Biegefeder befestigt sind. Zum Ausgleich von Nullpunktfehlern ist ein druckabhängiger Widerstand in einem dritten Brückenzweig ebenfalls innerhalb des Druckraumes angeordnet. Diese Anordnung läßt prinzipiell keine Trennung der Brücke in Sender- und Auswerteseite zu. Zudem ändern sich die Meßwiderstände im Druckraum gleichsinnig.

DE-OS 24 47 629 beschreibt eine Schaltungsanordnung zur Messung von Widerständen unter Verwendung einer Dreileiterschaltung zum Ausgleich von Leitungseinflüssen. Diese Anordnung hat gattungsmäßig mit vorliegender Erfindung keinerlei Verwandtschaft und gibt auch einzeln oder in Verbindung mit anderen bekannten Anordnungen keinen Hinweis auf die erfindungsgemäße Lösung.

DE-OS 34 35 867 betrifft einen magnetoresistiven Differentialsensor, bei dem die beiden magnetfeldabhängigen Widerstände mit ihren benachbarten Anschlüssen miteinander verbunden und stromdurchflossen sind. Die gemeinsame Verbindung der beiden Widerstände ist geerdet. Die freien Anschlüsse der Widerstände werden mit einem bei gleichbleibender Temperatur konstanten Strom beaufschlagt. Die Spannung zwischen den beiden freien Anschlüssen der Meßwiderstände wird als Sensorspannung verwendet. Parallel zu den Sensorwiderständen liegt ein hochohmiger Spannungsteiler aus gleich großen Widerständen. Die zwischen dem Mittenabgriff dieses Spannungsteilers und Erde abgegriffene Spannung wird mit einer Referenzspannung verglichen, um den Konstantstrom in den Sensorwiderständen unabhängig von der Temperatur konstant zu halten. Diese bekannte Schaltung arbeitet demnach mit Konstantstrom durchflossenen Widerständen, wobei es über die Erdung der Mittenanzapfung der in Reihe liegenden Widerstände eine Stromführung über Erde geben kann. Diese bleibt wohl kaum ohne nachteiligen Einfluß auf die Genauigkeit und Störunempfindlichkeit des Meßsignals.

Aufgabe vorliegender Erfindung ist es, die Nachteile vorstehend genannter bekannter Methoden und Anordnungen zu vermeiden und die für viele Anwendungsfälle dringend erforderliche Verbesserung zu schaffen. Insbesondere ist eine Einrichtung zur Erfassung und Übertragung einer Meßgröße zu schaffen, die genau, störungsarm, zuverlässig und anpassungsfähig arbeitet. Darüberhinaus soll es ermöglicht werden, Speisung und Auswertung von ein und derselben Seite her durchzuführen.

Diese Aufgabe wird erfindungsgemäß prinzipiell durch die im kennzeichnenden Teil des Anspruchs 1 niedergelegten Merkmale gelöst.

Mit der erfindungsgemäß gestalteten Einrichtung ergibt sich der wesentliche Vorteil einer genauen Erfassung der Meßgröße und einer sehr störungsarmen Übertragung dieser Meßgröße zur Auswerteinrichtung. Die Seite der Meßwerterfassung kann dabei ohne eigene Energieversorgung gestaltet sein. Darüberhinaus brauchen prinzipiell neben den Meßwertgebern sender- bzw. geberseitig weder aktive noch passive Bauelemente vorgesehen zu sein.

Vorteilhafte Ausgestaltungen sind in den abhängigen Patentansprüchen niedergelegt. Die sich daraus ergebenden Vorteile liegen entweder auf der Hand oder werden an passender Stelle nachfolgend noch beschrieben.

Als Meßwiderstände dienen die Innenwiderstände von Meßwertgebern, wie insbesondere Differentialfeldplatten oder fotoempfindliche Bauelemente.

In manchen Fällen ist eine Aufbereitung und Verstärkung der Meßgröße auf der Geber- bzw. Senderseite vor der Übertragung nicht zu umgehen. In solchen Fällen ist es gemäß einer weiteren Ausführungsform der Erfindung besonders zweckmäßig und vorteilhaft, als Meßwiderstand einen steuerbaren Halbleiterwiderstand, vorzugsweise den Bahnwiderstand eines Feldeffekttransistors vorzusehen. Dieser Widerstand wird in Abhängigkeit von der vorzugsweise optisch oder magnetisch erfaßten Meßgröße gesteuert oder geregelt.

Für die Verbindung zwischen Erfassung- bzw. Senderseite und Empfangs- bzw. Auswerteseite wird vorzugsweise ein mehradriges Kabel verwendet. Jedem Meßwiderstand ist eine eigene Ader zugeordnet. Die Versorgung mit eingeprägter Spannung erfolgt über eine gemeinsame Ader.

Es gibt in der Praxis öfters Anwendungen, bei denen ein und dieselbe Meßgröße mehrmals erfaßt wird. Beispielsweise können Winkelposition und Winkelgeschwindigkeit der Welle einer elektrischen Maschine nur dann mit Hilfe eines Geberpaares erfaßt werden, wenn sichergestellt ist, daß sich die Drehrichtung dieser Welle nicht ändert. Bei sich ändernder Drehrichtung ist eine eindeutige Erfassung der genannten Größen nur dann möglich, wenn ein zweites, vorzugsweise um 90° elektrisch versetzt angeordnetes, Geberpaar eingesetzt wird. Mit Hilfe eines dritten Geberpaares kann dann ggf. zusätzlich ein Referenzpunkt erfaßt werden. Gemäß einer vorteilhaften Weiterbildung der erfindungsgemäßen Einrichtung ist vorgesehen, daß mehrere derartige Einrichtungen, z.B. drei, verwendet werden und die Spannungseinprägung aus einer Quelle erfolgen kann.

Mit der Erfindung ist die Voraussetzung gegeben, eine Meßwiderstandsbrücke zu realisieren, deren eine Hälfte über sehr lange Leitungen, in der Praxis bis zu 100 m, empfängerseitig angeordnet ist. Auf der Senderseite ist keine Versorgungsquelle vorzusehen. Das Meßsystem ist extrem unempfindlich gegenüber Einstreuungen auf den Verbindungsleitungen. Ein entscheidender Beitrag dazu, der aus dem Stand der Technik nicht bekannt ist, ist die Einprägung der Spannung am gemeinsamen Verbindungspunkt der beiden Meßwiderstände auf der einen Seite und am gemeinsamen Verbindungspunkt der Brückenwiderstände auf der anderen Seite.

Nachfolgend wird die Erfindung anhand der in der Zeichnung dargestellten Ausführungsbeispiele näher erläutert. Dabei zeigen:

Fig. 1 eine prinzipielle Darstellung der wesentlichen Elemente einer ersten Ausführungsform vorliegender Erfindung und

Fig. 2 eine prinzipielle Darstellung der wesentlichen Elemente einer zweiten Ausführungsform der Erfindung.

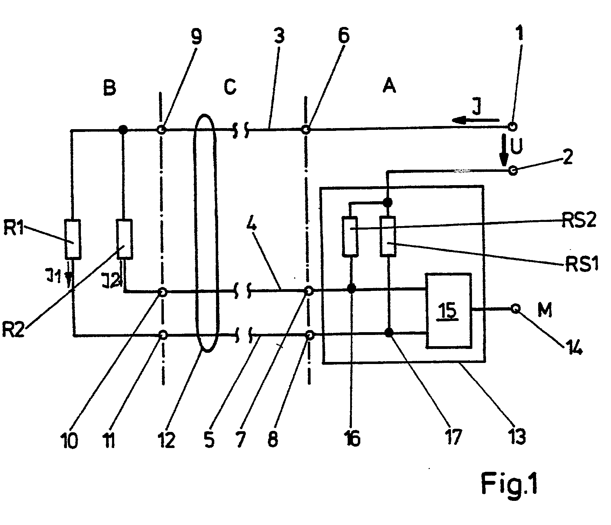

Gemäß der in Fig. 1 gezeigten Ausführungsform, die im Prinzip dargestellt ist, ist eine Empfangs- bzw. Auswerteseite A über eine Verbindung C mit der Erfassungs- bzw. Senderseite B verbunden. Auf der Erfassungs- bzw. Senderseite B sind zwei Meßwiderstände R1 und R2 angeordnet. Auf der Empfangs- bzw. Auswerteseite A ist eine Auswerteeinrichtung 13 vorgesehen. Desweiteren wird über zwei Klemmen 1 und 2 eine Spannung U mit einem Strom I eingeprägt. Der Strom I wird über Klemme 6 und Leitung 3 der Klemme 89 zugeführt, an der beide Meßwiderstände R1 und R2 gemeinsam angeschlossen sind. Die andere Seite des Meßwiderstandes R1 ist an Klemme 11 über eine separate Leitung 5 mit der Klemme 8 der Auswerteeinrichtung 13 verbunden. Ebenso ist in gleicher Weise der andere Anschluß des Wi        derstandes R2 über Klemme 10 und eine separate Leitung 4 mit der Anschlußklemme 7 der Auswerteeinrichtung 13 verbunden. Jedem Meßwiderstand R1 bzw. R2 ist demnach eine separate Leitung 5 bzw. 4 zur Verbindung mit der Auswerteeinrichtung 13 zugeordnet. Die Versorgungsleitung 3 ist beiden Meßwiderständen gemeinsam.

In der Auswerteeinrichtung 13 sind Reihenwiderstände RS1 und RS2 vorgesehen. Dabei ist der Reihenwiderstand RS1 mit dem Meßwiderstand R1 in Reihe geschaltet und der Reihenwiderstand RS2 mit dem Meßwiderstand R2 in Reihe geschaltet. Die Mittelanzapfung 16 zwischen dem Meßwiderstand R1 und dem zugeordneten Reihenwiderstand RS2 bildet einen Eingang einer Differenzmeßstufe 15. Die Mittelanzapfung 17 zwischen dem Meßwiderstand R1 und dem zugeordneten Reihenwiderstand RS1 bildet den zweiten Eingang der Differenzmeßstufe 15. Am Ausgang 14 der Differenzmeßstufe und damit auch der Auswerteeinheit 13 steht der Meßwert M der erfaßten und übertragenen Meßgröße an. Die Leitungen 3, 4 und 5 können Adern eines mahradrigen Kabels 12 sein. Dabei ist es vorteilhaft, wenn die Adern verdrillt bzw. abgeschirmt sind. Voraussetzung ist es allerdings nicht.

Die in Fig. 1 dargestellten Meßwiderstände R1 und R2 stellen symbolisch Meßwertgeber dar und können als deren Innenwiderstände aufgefaßt werden. Die in Fig. 1 dargestellte Brückenschaltung besteht auf der Senderseite und auf der Empfängerseite jeweils aus einer halben Brücke. Die senderseitigen Meßwiderstände ändern sich entsprechend der gewählten Meßwertgeber derart, daß bei Änderung der Meßgröße eine gegensinnige Änderung der Widerstandswerte erfolgt. Mit der gezeigten Ausführungsform ist ein ggf. erforderlicher Abgleich der Anordnung auf der Empfangs- bzw. Auswerteseite A in einfacher Weise möglich.

Wie erkennbar, erfolgt die Speisung und Auswertung von der Empfangs- bzw. Auswerteseite A her. Somit werden sowohl symmetrische als auch asymmetrische Störströme bestmöglichst unterdrückt. Die Amplitude der Meßströme ist im wesentlichen durch die Maximalleistung und die Spannungsfestigkeit der Meßwiderstände bestimmt. Alle aktiven Komponenten der Anordnung können hochohmig von der Leitung abgekoppelt sein, um dadurch eine Anregung dieser Komponenten durch Störspitzen bestmöglichst zu vermeiden. Darüberhinaus ist vorteilhaft, daß die Erfassung der Meßgröße mit einer minimalen Anzahl von Adern der Übertragungsleitung 12 ermöglicht ist. Von besonderem Vorteil ist, daß hohe Meßströme ohne Vorhandensein aktiver Komponenten auf der Erfassungs- bzw. Senderseite B, das heißt da wo die Meßwertgeber angeordnet sind, möglich sind.

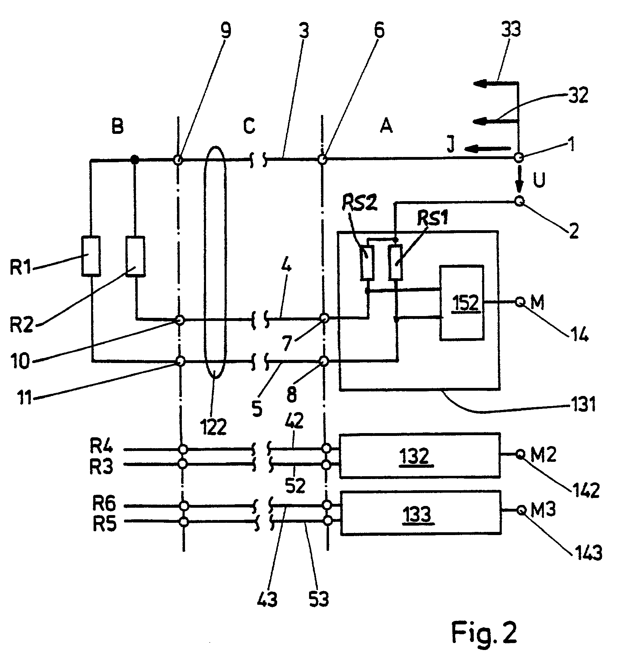

Bei der in Fig. 2 dargestellten Ausführungsform ist auf der Auswerteseite A ebenfalls die in Fig. 1 gezeigte Halbbrücke vorgesehen.

Die Fig. 2 zeigt weiterhin auf der Empfangs- bzw. Auswerteseite A an der Klemme 1 angeschlossen zwei Leitungen 32 und 33, die parallel zur Leitung 3 sind. Es erfolgt hier eine Stromaufteilung, so daß in jeder Leitung 3, 32, 33 der Strom I fließen kann. Desweiteren zeigt die Fig. 2 im unteren Bereich eine zweite Auswerteeinrichtung 132.

Dieser werden Werte von einem zweiten Paar von Meßwiderständen R3 und R4 über Leitungen 52 und 42 zugeführt.

Am Ausgang 142 steht der Meßwert M2 an. Ebenso ist ein weiteres Paar von Meßwiderständen R5 und R6 über Leitungen 53 und 43 mit einer dritten Auswerteeinrichtung 133 verbunden. Am Ausgang 143 dieser Auswerteeinrichtung 133 steht der Meßwert M3 an. Jedem einzelnen der Widerstände R1 bis R6 ist zur Verbindung von der Erfassungs-bzw. Senderseite B zur Verbindung mit der Empfangs- bzw. Auswerteseite A eine separate Leitung 4, 5 bzw. 42, 52 bzw. 43, 53 zugeordnet. Desweiteren ist jedem Paar von Meßwiderständen eine gemeinsame Versorgungsleitung 32 bzw. 33 zugeordnet, die aus einer gemeinsamen Quelle, dargestellt durch das Bezugszeichen 1, gespeist werden. Alle Leitungen können Teil eines mehradrigen Kabels 122 sein.

Die erweiterte Anordnung, die den Einsatz mehrerer Paare von Meßwiderständen beinhaltet, ist in der Praxis bei Anwendungen von Vorteil, bei denen ein und dieselbe Meßgröße mehrmals erfaßt wird. Dies ist beispielsweise bei allen Drehbewegungen der Fall, bei welchen unabhängig von der Drehrichtung einer elektrischen Maschine eine eindeutige Information über die Weinkelgeschwindigkeit sowie über die Winkellage gewonnen werden soll.

Die in den Figuren dargestellten Paare von Meßwiderständen R1, R2 bzw. R3, R4 bzw. R5, R6 stellen die Innenwiderstände von Meßwertgebern dar. In der Praxis werden sie beispielsweise gebildet durch Feldplatten-Differential-Fühler oder durch Meßwertgeber, die aus fotoempfindlichen Bauelementen aufgebaut sind.

Es gibt auch Anwendungen, bei denen eine Aufbereitung und Verstärkung der auf der Erfassungs- bzw. Senderseite erfaßten Meßwerte notwendig ist, bevor die Übertragung erfolgt. Die entsprechenden sich gegenläufig ändernden Meßwiderstände R1 und R2 sind dann gemäß einer weiteren vorteilhaften Ausgestaltung der Erfindung steuerbare Halbleiterwiderstände. Insbesondere sind dazu die Bahnwiderstände von Feldeffekttransistoren geeignet. Die Widerstände werden in Abhängigkeit der vorzugsweise optisch oder magnetisch erfaßten Meßgröße gesteuert bzw. geregelt. Diese Art der Meßwertaufbereitung mit Hilfe steuerbarer Widerstände schafft die Voraussetzung, daß an ein und dieselbe Auswerteeinrichtung verschiedene Meßwertgeber angeschlossen werden können. In der Praxis ist das ein wesentlicher Vorteil.

**Patentansprüche**

1. Einrichtung zur Erfassung und Übertragung einer Meßgröße, insbesondere einer Gleichgröße mit überlagertem Wechselanteil, mit Hilfe von zwei Meßwiderständen (R1, R2), deren Widerstandswert durch die Meßgröße auf der Erfassungs- bzw. Senderseite (B) vorzugsweise gegenläufig veränderbar ist, sowie mit Hilfe einer Verbindung (C) zwischen der Erfassungs-bzw. Senderseite (B) und einer Auswerteeinrichtung auf der Empfangs- bzw. Auswerteseite, wobei die beiden Meßwiderstände (R1, R2) auf einer Seite miteinander verbunden und jeder Meßwiderstand auf seiner anderen freien Seite separat über eine separate Leitung (4, 5) mit der Auswerteeinheit (13) verbunden ist, dadurch gekennzeichnet , daß die Meßwiderstände (R1, R2) an ihrer gemeinsamen Verbindung (9) von der Empfangs- bzw. Auswerteseite (A) her über eine separate Leitung (3) mit eingeprägter Spannung (U) gespeist werden, daß die beiden Meßwiderstände (R1, R2) jeweils durch in der Auswerteeinrichtung (13) vorgesehene Reihenwiderstände (RS1, RS2) zu einer Brückenschaltung ergänzt sind, und daß eine Differenzmeßstufe (15) eingangsseitig mit den Mittenanzapfungen (16, 17) der Brückenschaltung verbunden ist.

2. Einrichtung nach Anspruch 1, dadurch gekennzeichnet, daß jeder Meßwiderstand (R1,R2) aus dem Innenwiderstand eines Meßwertgebers gebildet ist.

3. Einrichtung nach Anspruch 2, dadurch gekennzeichnet, daß die beiden Meßwiderstände (R1,R2) aus den beiden Innenwiderständen eines Differentialfeldplatten enthaltenden Meßwertgebers oder eines fotoempfindliche Bauelemente enthaltenden Meßwertgebers gebildet sind.

4. Einrichtung nach Anspruch 1, dadurch gekennzeichnet, daß jeder Meßwiderstand (R1,R2) aus einem steuerbaren Halbleiter gebildet ist, insbesondere dem Bahnwiderstand eines Feldeffekttransistors, wobei dessen Widerstand in Abhängigkeit der vorzugsweise optisch oder magnetisch erfaßten Meßgröße gesteuert oder geregelt wird.

5. Einrichtung nach einem der vorigen Ansprüche, dadurch gekennzeichnet, daß bei Verwendung von mehreren Paaren von Meßwertwiderständen (R1,R2;R3,R4;R5,R6) für die Erfassung der Meßgröße, die Einprägung der Spannung (U) von der Empfangs- bzw. Auswertseite (A) her parallel (3,32,33) aus einer gemeinsamen Quelle (1) erfolgt.

6. Einrichtung nach einem der vorigen Ansprüche, dadurch gekennzeichnet,daß die Leitungen (3,4,5 bzw. 32, 42, 52 bzw. 33,43,53) Adern eines mehradrigen Kabels (12,122) sind, wobei für jeden einzelnen Meßwiderstand (R1 - R6) eine separate Ader (4,5;42,52;43,53) als Verbindung zur jeweiligen Auswerteeinrichtung (13,131,132,133) vorgesehen ist.

**Claims**

1. Apparatus for detecting and transmitting a measured value, especially an equivalent value with superimposed alternating proportion, with the aid of two measuring resistors (R1, R2), the resistance value of which is variable preferably in opposite direction by the measured value on the detection or transmission side (B) and with the aid of a connection (C) between the detection side or transmission side (B) as the case may be and an evaluator apparatus on the reception or evaluation side (A), the two measuring resistors (R1, R2) being connected with one another on one side and each measuring resistor being connected on its other, free side separately through a separate lead (4, 5) with the evaluator unit (13), characterised in that the measuring resistors (R1, R2) are fed with impressed voltage (U) at their common connection (9) from the reception or evaluation side (A), through a separate lead (3), in that the two measuring resistors (R1, R2) are supplemented each by series resistors (RS1, RS2) provided in the evaluator apparatus (13) to form a bridge circuit, and in that a difference-measuring stage (15) is connected on the input side with the centre tappings (16, 17) of the bridge circuit.

2. Apparatus according to Claim 1, characterised in that each measuring resistor (R1, R2) is formed from the internal resistance of a measured value emitter.

3. Apparatus according to Claim 2, characterised in that the two measuring resistors (R1, R2) are formed from the two internal resistances of a measured value emitter containing differential field plates or of a measured value emitter containing photo-sensitive components.

4. Apparatus according to Claim 1, characterised in that each measuring resistor (R1, R2) is formed from a controllable semi-conductor, especially the path resistance of a field effect transistor, its resistance being controlled or regulated in dependence upon the preferably optically or magnetically detected measured value.

5. Apparatus according to one of the preceding Claims, characterised in that when several pairs of measured value resistors (R1, R2, R3, R4, R5. R6) are used for the detection of the measured value. The impression of the voltage (U) takes place parallel (3, 32, 33) from the reception or evaluation side (A) from a common source (1).

6. Apparatus according to one of the preceding Claims, characterised in that the leads (3, 4, 5 or 32, 42, 52 or 33, 43, 53) are cores of a multi-core cable (12, 122), and a separate core (4, 5; 42, 52; 43, 53) is provided as connection to the respective evaluator device (13, 131, 132, 133) for each individual measuring resistor (R1 – R6).

**Revendications**

1. Dispositif pour détecter et pour transmettre une grandeur de mesure, en particulier une grandeur continue avec une composante alternative superposée, à l'aide de deux résistances de mesure (R1, R2) dont la valeur de résistance peut être variée par la grandeur de mesure du côté détection et respectivement émetteur (B), de préférence en sens opposé, ainsi qu'à l'aide d'une liaison (C) entre le côté détection et respectivement émetteur (B) et un dispositif d'interprétation (13) du côté réception et respectivement interprétation (A), les deux résistances de mesure (R1, R2) étant reliées entre elles sur l'un des côtés et le côté libre de chacune des résistances de mesure étant relié séparément, par l'intermédiaire d'une ligne séparée (4, 5), à l'unité d'interprétation (13), caractérisé en ce que les résistances de mesure (R1, R2) sont alimentées à leur branchement commun (9), à partir du côté réception et respectivement interprétation (A), par l'intermédiaire d'une ligne séparée (3), avec une tension appliquée (U); que les deux résistances de mesure (R1, R2) sont respectivement complétées en un montage en pont par des résistances en série (RS1, RS2) prévues dans le dispositif d'interprétation (13); et que l'entrée d'un étage de mesure différentielle (15) est reliée aux prises médianes (16, 17) du montage en pont.

2. Dispositif selon la revendication 1, caractérisé en ce que chaque résistance de mesure (R1, R2) est constituée par la résistance interne d'un capteur de mesure.

3. Dispositif selon la revendication 2, caractérisé en ce que les deux résistances de mesure (R1, R2) sont constituées par les deux résistances internes d'un capteur de mesure contenant des magnétorésistances différentielles ou d'un capteur de mesure contenant des éléments photosensibles.

4. Dispositif selon la revendication 1, caractérisé en ce que chaque résistance de mesure (R1, R2) est constituée par un semiconducteur commandable, en particulier par la résistance de volume d'un transistor à effet de champ, la résistance de celui-ci étant commandée et respectivement réglée en fonction de la grandeur de mesure détectée de préférence de manière optique ou magnétique.

5. Dispositif selon l'une des revendications précédentes, caractérisé en ce que, dans le cas de l'utilisation de plusieurs paires de résistances de mesure (R1, R2, R3, R4, R5, R6) pour la détection de la grandeur de mesure, l'application de la tension (U) se fait à partir du côté réception et respectivement interprétation (A), parallèlement (3, 32, 33) à partir d'une source commune (1).

6. Dispositif selon l'une des revendications précédentes, caractérisé en ce que les lignes (3, 4, 5 et respectivement 32, 42, 52 et respectivement 33, 43, 53) sont des conducteurs d'un câble multiconducteur (12, 122), pour chacune des résistances de mesure (R1 à R6) étant prévu un conducteur séparé (4, 5; 42, 52; 43, 53) comme liaison avec le dispositif d'interprétation respectif (13, 131, 132, 133).

Fig.1

Fig. 2